# EUROPÄISCHE PATENTSCHRIFT

(11) **EP 0 825 969 B1**
(45) Veröffentlichungstag und Bekanntmachung des Hinweises auf die Patenterteilung: **04.08.1999**
(21) Anmeldenummer: 97907092.7
(22) Anmeldetag: 11.03.1997
(51) Int. Cl.: C04B 35/56, C04B 35/58, H01L 39/12

(54) **VERFAHREN ZUR HERSTELLUNG VON SUPRALEITER-FORMKÖRPERN**
METHOD OF PRODUCING SHAPED SUPERCONDUCTOR BODIES
PROCEDE DE PRODUCTION DE CORPS MOULES SUPRACONDUCTEURS

(30) Priorität: 14.03.1996 DE 19609983
(43) Veröffentlichungstag der Anmeldung: 04.03.1998
(73) Patentinhaber: Institut für Festkörper- und Werkstofforschung Dresden e.V., 01069 Dresden (DE)
(72) Erfinder: ECKERT, Jürgen, D-01139 Dresden (DE); JOST, Kathrin, D-16303 Schwedt (DE); DE HAAS, Oliver, D-01324 Dresden (DE); SEIDEL, Michael, D-01309 Dresden (DE); SCHULTZ, Ludwig, D-01474 Dresden (DE)
(74) Vertreter: Rauschenbach, Dieter
(86) Internationale Anmeldenummer: EP9701233
(87) Internationale Veröffentlichungsnummer: WO9733844

(56) Entgegenhaltungen:
- EP-A- 0 650 204

## Beschreibung

### Technisches Gebiet

Die Erfindung betrifft ein Verfahren zur Herstellung von Supraleiter-Formkörpern aus Seltenerd-Übergangsmetall-Borcarbid- und -Bornitrid-Verbindungen.

### Stand der Technik

Es sind bereits Seltenerd-Übergangsmetall-Borcarbid- und -Bornitrid-Verbindungen mit Supraleitereigenschaften bekannt, mit denen Sprungtemperaturen von bis zu 23 K erreicht werden. Bisher eingehend untersucht wurden dabei die Vertreter der Se-Ni-B-C-Systeme (SE = Y, Tm, Er, Ho, Lu, Dy), wobei SE Ni₂B₂C als supraleitende Phase identifiziert wurde (R. J. Cava et. al., Nature 367,252(1994)).

Weitere supraleitende Phasen mit Sprungtemperaturen von 6 bis 15 K wurden für die Verbindungen SE Ni₄B₄C (SE = Y, Tm, Er, Ho), für YNi₄BC_{0,2} und für YNi₂B₃C_{0,2} gefunden (Q.W. Yan et. al., Phys. Rev. B 51, 8395 (1995); R. Nagarajan et. al., Phys. Rev. Lett. 72,274(1994)). Selbst ohne weitere Material-optimierung liegen die Sprungtemperaturen damit im Bereich der klassischen A15-Supraleiter.

Zur Herstellung von Seltenerd-Übergangsmetall-Borcarbid- und -Bornitrid-Verbindungen für Supraleiter ist die Anwendung schmelzmetallurgischer Verfahren bekannt. Dabei erfordern die hohen Schmelztemperaturen der intermetallischen Borcarbid- und -Bornitrid-Supraleiter eine Präparation über Lichtbogen- oder Schwebeschmelzverfahren. Bislang wurden auf diese Weise überwiegend polykristalline Proben hergestellt (beispielsweise: M. Buchgeister et al., Mat. Lett. 22,203(1995)). Außerdem wurden auch entsprechende Einkristalle präpariert (beispielsweise: T. Grigereit et al. Phys. Rev. Lett. 73,2756 (1995)).

Aus der EP-A-0 650 204 ist ein intermetallisches Supraleitermaterial bekannt, das B und C, ein odere mehrere Metalle (z.B. Ni, Pd, Pt) und ein oder mehrere Elemente aus einer mit Y, den Seltenenerdelementen der Lanthangruppe und den alkalischen Erden gebildeten Gruppe enthält. Zur Herstellung dieses Supraleitermaterials werden die Ausgangsmaterialien zum Teil in Form grober Pulvern, kleiner Klumpen und in Form von Spänen miteinander vermischt. Danach wird die entstandene Mischung zu kleinen Pellets verpreßt. Diese werden dann unter Ar im Lichtbogenofen aufgeschmolzen.

Die schmelzmetallurgische Herstellung führt durch selektives Abdampfen einzelner Komponenten zu Problemen bezüglich der erforderlichen genauen Einstellung der Stöchiometrie beziehungsweise bei der Herstellung phasenreiner Materialien (M. Buchgeister et al., Mat. Lett. 22,203(1995)). Andererseits ist die Phasenbildung durch die Thermodynamik im Rahmen der Gleichgewichtsphasendiagramme bestimmt. So konnte beispielsweise im System Y-Pd-B-C bei der schmelzmetallurgischen Herstellung zwar eine hohe Sprungtemperatur von 23 K erzielt werden, jedoch gelang es bisher nicht, die entsprechende Supraleiterphase phasenrein zu isolieren (Y.Y. Sun et al. Physica C 230,435(1994)).

Bekannt ist es auch, bandförmige Borcarbidsupraleiter mit der nominellen Zusammensetzung YNi₂B₂C mittels dem Verfahren der Rascherstarrung herzustellen, wobei eine teilweiseAmorphisierung bei der Erstarrung eintritt (V. Ström et al. Physica C 235-240,2537(1994)). Die erzielten YNi₂B₂C-Kristallite liegen hierbei vermutlich in einer Borreichen amorphen Matrix vor. Kompakte Formkörper können mit dem Verfahren der Rascherstarrung nicht hergestellt werden.

Schließlich ist es bekannt, Borcarbidsupraleiter mittels Sputtern dünner Schichten zu erzeugen (S. Arisawa et al. Appl. Phys. Lett. 65,1299(1994)). Hierbei wurden 300 nm dicke amorphe Y-Pd-B-C-Filme durch Abscheiden auf Mg-O-Substraten bei Raumtemperatur erzeugt. Die bei der Abscheidung entstandene amorphe Phase wird durch nachfolgendes Glühen bei 1050 °C in die supraleitende YNi₂B₂C-Phase überführt. Damit liegt die Kristallisationstemperatur in nachteiliger Weise im Bereich derjenigen Temperaturen, die typischerweise bei der schmelzmetallurgischen Herstellung zur Anwendung gelangen. Proben, die unterhalb dieser Temperatur, z.B. bei 900 °C geglüht werden, zeigen keine supraleitenden Eigenschaften. Die Herstellung kompakter Formkörper ist auch mit diesem Verfahren nicht möglich.

### Darstellung der Erfindung

Der Erfindung liegt die Aufgabe zugrunde, die Herstellung kompakter Formkörper aus Seltenerd-Übergangsmetall-Borcarbidund -Bornitrid-Verbindungen so zu gestalten, daß im Herstellungsprozeß ein selektives Abdampfen einzelner Komponenten vermieden und eine genaue Einstellung der gewünschten Stöchiometrie möglich wird.

Diese Aufgabe wird mit dem in den Patentansprüchen beschriebenen Verfahren gelöst.

Das Verfahren ist dadurch gekennzeichnet, daß man
a) eine Pulvermischung mit Teilchengrößen von 1 bis 250µm, herstellt, enthaltend
   aa) mindestens ein Element aus der Gruppe Y, La, Ho, Dy, Er, Tm, Lu, Sc,
   ab) mindestens ein Element aus der Gruppe Ni, Cu, Co, Fe, Pd, Pt,
   ac) B und N und/oder Carbide und Nitride und/oder deren Mischkristalle,
b) diese Pulvermischung mittels hoher mechanischer Kräfte, insbesondere durch mechanisches Legieren oder Intensivmahlen zu einem Sekundärpulver mit amorpher, nanokristalliner oder amorph-nanokristalliner Struktur umwandelt,
c) das Sekundärpulver zur Bildung von supraleitenden Phasen in an sich bekannter Weise wärmebehandelt, wobei man jedoch Bildungstemperaturen anwendet, die unterhalb der nach schmelzmetallurgischen und Rascherstarrungsverfahren angewandten Bildungstemperaturen liegen, und daß man
d) das Sekundärpulver durch Verpressen zu Supraleiter-Formkörpern kompaktiert, wobei Temperaturen angewandt werden, die unterhalb der Umwandlungstemperatur des Werkstoffs liegen.

Gemäß einer vorteilhaften Ausgestaltung der Erfindung wird eine Pulvermischung hergestellt, welche die Komponenten Y:Ni:B:C oder Y:Pd:B:C im Atomverhältnis von 1:2:2:1 enthält. Dabei kann die Pulvermischung aus Elementpulver oder aus Vorlegierungen von mindestens 2 der Komponenten oder aus einer Mischung von Vorlegierungen und Elementpulver hergestellt werden.

Zweckmäßigerweise wird das mechanische Legieren oder Intensivmahlen mittels einer Planeten-Kugelmühle, einer Schwingmühle, einer Vibrationsmühle oder einem Attritor durchgeführt.

Bei Vorliegen eines überwiegend amorphen Sekundärpulvers wird das Verpressen bei Temperaturen durchgeführt, die mindestens 20 K unter der Kristallisationstemperatur der amorphen Phase des Werkstoffs liegen.

Bei Vorliegen eines überwiegend nanokristallinen Sekundärpulvers mit amorphen Phasenanteilen von <50% wird das Verpressen bei Temperaturen nahe unter der Kristallisationstemperatur der amorphen Phase durchgeführt.

Im Falle des Vorliegens eines vollständig nanokristallinen Sekundärpulvers wird das Verpressen bei Temperaturen durchgeführt, die unterhalb der Umwandlungstemperatur der vorliegenden supraleitenden Phase des Werkstoffs liegen. Bei den im Zusammenhang mit der Erfindung vorliegenden Phasen sind dies vorzugsweise Preßtemperaturen unterhalb von 900 °C.

Die Kompaktierung zu Supraleiter-Formkörpern wird in zweckmäßiger Weise mittels Heißpressen, Strangpressen, Extrudieren, heißisostatischem Pressen oder Sinterhippen durchgeführt.

Gemäß einer vorteilhaften Ausgestaltung der Erfindung werden die Wärmebehandlung zur Bildung von supraleitenden Phasen und das Verpressen zur Herstellung der Supraleiter-Formkörper in einer gemeinsamen technologischen Stufe durchgeführt.

Das erfindungsgemäße Verfahren zeichnet sich gegenüber dem Stand der Technik dadurch aus, daß bei der Herstellung kompakter Formkörper aus Seltenerd-Übergangsmetall-Borcarbidund -Bornitrid-Verbindungen ein selektives Abdampfen einzelner Komponenten vermieden und eine genaue Einstellung der gewünschten Stöchiometrie möglich wird. Die Bildung der Verbindungen erfolgt in vorteilhafter Weise unterhalb derjenigen Temperaturen, die bei den bisher gängigen Verfahren angewandt werden. Infolge der Herstellung einer amorphen Phase oder einer amorph-nanokristallinen Phasenmischung können durch Umformung bei Temperaturen, die unter der Kristallisationstemperatur liegen, Supraleiter-Formkörper mit einer hohen Dichte von ≥80% hergestellt werden.

### Beste Wege zur Ausführung der Erfindung

Nachstehend ist die Erfindung an Hand von Ausführungsbeispielen näher erläutert, wobei der Weg gemäß Beispiel 1 als besonders vorteilhaft anzusehen ist.

### Beispiel 1

Handelsübliche Y-, Ni-, B- und C-Pulver mit mittleren Teilchengrößen von 44 bis 500 µm werden im Verhältnis Y:Ni:B:C von 1:2:2:1 (Atom-%) unter Ar-Schutzgas gemischt und in einer Vibrationsmühle gemahlen. Der Mahlvorgang erfolgt unter Verwendung von Wälzlagerkugeln mit einem Durchmesser von 10 mm. Das Massenverhältnis Kugeln zu Pulver ist 15:1. Das Mahlgefäß hat ein Volumen von 250 ml und die Mahlgeschwindigkeit beträgt 160 min⁻¹. Der Mahlvorgang wird mit einer Dauer von 200 h durchgeführt, wobei im Mahlgut nach bereits 64 h eine kristalline YNi₂B₂C-Phase neben einer amorphen Phase vorliegt.

Am Ende des Mahlvorganges liegt ein Sekundärpulver vor, das überwiegend amorph ist und nanokristalline YNi₂B₂C-Phasenanteile enthält.

Das erhaltene amorph/nanokristalline Sekundärpulver wird dann in einer Argonatmosphäre bei einer Temperatur von 530-555 °C zur vollständigen Bildung der supraleitenden YNi₂B₂C-Phasen wärmebehandelt. Gleichzeitig wird das Pulver mittels Heißpressen mit einem Druck von 6-10 bar zu Formkörpern verpreßt. Die so erhaltenen Formkörper weisen eine Dichte von 80 % auf. Mit höherem Preßdruck sind auch nahezu vollständig dichte Körper erreichbar.

### Beispiel 2

Handelsübliche Y-, Ni-, B- und C-Pulver mit mittleren Teilchengrößen von 44 bis 500 µm werden im Verhältnis Y:Ni:B:C von 1:2:2:1 (Atom-%) unter Ar-Schutzgas gemischt und in einer Vibrationsmühle gemahlen. Der Mahlvorgang erfolgt unter Verwendung von Wälzlagerkugeln, die zum Teil einen Durchmesser von 10 mm und zum anderen Teil einen Durchmesser von 5 mm aufweisen. Das Massenverhältnis Kugeln zu Pulver ist 10:1. Das Volumen des Mahlgefäßes beträgt 100 ml und die Mahlfrequenz 12,3 Hz. Der Mahlvorgang wird mit einer Dauer von 300 h durchgeführt, wobei im Mahlgut nach bereits 8 h eine kristalline YNi₂B₂C-Phase neben einer amorphen Phase vorliegt. Am Ende des Mahlvorganges liegt ein Sekundärpulver vor, das überwiegend amorph ist und nanokristalline YNi₂B₂C-Phasenanteile enthält.

Das nach einer Mahlung von 300 h erhaltene amorph/nanokristalline YNi₂B₂C-Pulver wird dann in einer Argonatmosphäre bei einer Temperatur von 530-555 °C zur vollständigen Bildung von supraleitenden Phasen wärmebehandelt. Gleichzeitig wird das Pulver mittels Heißpressen mit einem Druck von 6-10 bar zu Formkörpern verpreßt. Die so erhaltenen Formkörper weisen eine Dichte von 80 % auf.

### Beispiel 3

Handelsübliche Y-, Pd-, B- und C-Pulver mit mittleren Teilchengrößen von 44 bis 500 µm werden im Verhältnis Y:Pd:B:C von 1:2:2:1 (Atom-%) unter Ar-Schutzgas gemischt und in einer Vibrationsmühle gemahlen. Der Mahlvorgang erfolgt unter Verwendung von Wälzlagerkugeln, die zum Teil einen Durchmesser von 10 mm und zum anderen Teil einen Durchmesser von 5 mm aufweisen. Das Massenverhältnis Kugeln zu Pulver ist 10:1. Das Volumen des Mahlgefäßes beträgt 100 ml und die Mahlfrequenz 12,3 Hz. Der Mahlvorgang wird mit einer Dauer von 300 h durchgeführt, wobei im Mahlgut nach bereits 16 h eine kristalline YPd₂B₂C-Phase vorliegt. Am Ende des Mahlvorganges liegt ein Sekundärpulver vor, das nanokristallin ist und überwiegend aus der supraleitenden Phase YPd₂B₂C besteht.

Das erhaltene nanokristalline Sekundärpulver wird dann in einer Argonatmosphäre unterhalb einer Temperatur von 900 °C wärmebehandelt. Gleichzeitig wird das Pulver mittels Heißpressen mit einem Druck von 6-10 bar zu Formkörpern verpreßt. Die so erhaltenen Formkörper weisen eine Dichte von etwa 80 % auf.

## Patentansprüche

1. Verfahren zur Herstellung von Supraleiter-Formkörpern aus Seltenerd-Übergangsmetall-Borcarbid- und -Bornitrid-Verbindungen, indem man
a) eine Pulvermischung mit Teilchengrößen von 1 bis 250µm, herstellt, enthaltend
aa) mindestens ein Element aus der Gruppe Y, La, Ho, Dy, Er, Tm, Lu, Sc,
ab) mindestens ein Element aus der Gruppe Ni, Cu, Co, Fe, Pd, Pt,
ac) B und N und/oder Carbide und Nitride und/oder deren Mischkristalle,
b) diese Pulvermischung mittels hoher mechanischer Kräfte, insbesondere durch mechanisches Legieren oder Intensivmahlen zu einem Sekundärpulver mit amorpher, nanokristalliner oder amorph-nanokristalliner Struktur umwandelt,
c) das Sekundärpulver zur Bildung von supraleitenden Phasen in an sich bekannter Weise wärmebehandelt, wobei man jedoch Bildungstemperaturen anwendet, die unterhalb der nach schmelzmetallurgischen und Rascherstarrungsverfahren angewandten Bildungstemperaturen liegen, und indem man
d) das Sekundärpulver durch Verpressen zu Supraleiter-Formkörpern kompaktiert, wobei Temperaturen angewandt werden, die unterhalb der Umwandlungstemperatur des Werkstoffs liegen.

2. Verfahren nach Anspruch 1, dadurch gekennzeichnet, daß eine Pulvermischung hergestellt wird, welche die Komponenten Y:Ni:B:C oder Y:Pd:B:C im Atomverhältnis von 1:2:-2:1 enthält.

3. Verfahren nach Anspruch 2, dadurch gekennzeichnet, daß die Pulvermischung aus Elementpulver oder aus Vorlegierungen von mindestens 2 der Komponenten oder aus einer Mischung von Vorlegierungen und Elementpulver hergestellt wird.

4. Verfahren nach Anspruch 1, dadurch gekennzeichnet, daß das mechanische Legieren oder Intensivmahlen mittels einer Planeten-Kugelmühle, einer Schwingmühle, einer Vibrationsmühle oder einem Attritor durchgeführt wird.

5. Verfahren nach Anspruch 1, dadurch gekennzeichnet, daß bei Vorliegen eines überwiegend amorphen Sekundärpulvers das Verpressen bei Temperaturen durchgeführt wird, die mindestens 20 K unter der Kristallisationstemperatur der amorphen Phase des Werkstoffs liegen.

6. Verfahren nach Anspruch 1, dadurch gekennzeichnet, daß bei Vorliegen eines überwiegend nanokristallinen Sekundärpulvers mit amorphen Phasenanteilen von <50% das Verpressen bei Temperaturen nahe unter der Kristallisationstemperatur der amorphen Phase durchgeführt wird.

7. Verfahren nach Anspruch 1, dadurch gekennzeichnet, daß bei Vorliegen eines vollständig nanokristallinen Sekundärpulvers das Verpressen bei Temperaturen durchgeführt wird, die unterhalb der Umwandlungstemperatur der vorliegenden supraleitenden Phase des Werkstoffs liegen.

8. Verfahren nach Anspruch 7, dadurch gekennzeichnet, daß bei Vorliegen eines vollständig nanokristallinen Sekundärpulvers das Verpressen bei Temperaturen unterhalb von 900 °C durchgeführt wird.

9. Verfahren nach Anspruch 1, dadurch gekennzeichnet, daß die Kompaktierung zu Supraleiter-Formkörpern mittels Heißpressen, Strangpressen, Extrudieren, heißisostatischem Pressen oder Sinterhippen durchgeführt wird.

10. Verfahren nach Anspruch 1, dadurch gekennzeichnet, daß die Wärmebehandlung zur Bildung von supraleitenden Phasen und das Verpressen zur Herstellung der Supraleiter-Formkörper in einer gemeinsamen technologischen Stufe durchgeführt werden.

## Claims

1. Process for the production of shaped superconductor articles from rare earth-transition metal-boron carbide and -boron nitride compounds in which
a) a powder mixture having particle sizes of 1 to 250 µm comprising
aa) at least one element from the group consisting of Y, La, Ho, Dy, Er, Tm, Lu, Sc,
ab) at least one element from the group consisting of Ni, Cu, Co, Fe, Pd, Pt,
ac) B and N and/or carbides and nitrides and/or mixed crystals thereof,
is prepared
b) this powder mixture is converted into a secondary powder with an amorphous, nanocrystalline or amorphous-nanocrystalline structure by means of high mechanical forces, in particular by mechanical alloying or intensive grinding,
c) the secondary powder is heat-treated in a manner known per se to form superconducting phases, but using formation temperatures which are below the formation temperatures used in melting metallurgy and rapid solidification processes, and in which
d) the secondary powder is compacted to shaped superconductor articles by pressing, using temperatures below the transformation temperature of the material.

2. Process according to claim 1, characterized in that a powder mixture which comprises components Y:Ni:B:C or Y:Pd:B:C in an atomic ratio of 1:2:2:1 is prepared.

3. Process according to claim 2, characterized in that the powder mixture is prepared from elemental powders or from pre-alloys of at least 2 of the components or from a mixture of pre-alloys and elemental powders.

4. Process according to claim 1, characterized in that the mechanical alloying or intensive grinding is carried out by means of a planetary ball mill, an oscillating mill, a vibration mill or an attritor.

5. Process according to claim 1, characterized in that if a predominantly amorphous secondary powder is present, the pressing is carried out at temperatures which are at least 20 K below the crystallization temperature of the amorphous phase of the material.

6. Process according to claim 1, characterized in that if a predominantly nanocrystalline secondary powder with amorphous phase contents of <50% is present, the pressing is carried out at temperatures just below the crystallization temperature of the amorphous phase.

7. Process according to claim 1, characterized in that if a completely nanocrystalline secondary powder is present, the pressing is carried out at temperatures below the transformation temperature of the superconducting phase present in the material.

8. Process according to claim 7, characterized in that if a completely nanocrystalline secondary powder is present, the pressing is carried out at temperatures below 900°C.

9. Process according to claim 1, characterized in that the compacting to shaped superconductor articles is carried out by means of hot pressing, extrusion pressing, extrusion, hot isostatic pressing or sintering by the HIP process.

10. Process according to claim 1, characterized in that the heat treatment to form superconducting phases and the pressing for production for the shaped superconductor articles are carried out in a joint technological stage.

## Revendications

1. Procédé de fabrication de corps moulés supraconducteurs, constitués de combinaisons terre rare-métal de transition, carbure de bore et nitrure de bore, dans lequel
a) on fabrique un mélange pulvérulent ayant des grandeurs de particules allant de 1 à 250 µm, contenant :
aa) au moins un élément issu du groupe Y, La, Ho, Dy, Er, Tm, Lu, Sc,
ab) au moins un élément issu du groupe Ni, Cu, Co, Fe, Pd, Pt,
ac) B et N et/ou des carbures ou des nitrures et/ou leurs cristaux mixtes,
b) ce mélange pulvérulent est converti au moyen d'efforts mécaniques, en particulier par alliage mécanique ou par broyage intensif, en une poudre secondaire ayant une structure amorphe, nanocristalline ou amorphe-nano-cristalline,
c) la poudre secondaire est traitée thermiquement de manière connue en soi, pour former des phases supraconductrices, cependant en utilisant des températures de formation inférieures aux températures de formation utilisées dans la métallurgie de la fusion et dans les procédés à solidification rapide et,
d) on compacte la poudre secondaire par compression, pour donner des corps moulés supraconducteurs, en utilisant des températures inférieures à la température de conversion du matériau.

2. Procédé selon la revendication 1,
caractérisé en ce qu'
on fabrique un mélange de poudre qui contient les composants Y:Ni:B:C ou Y:Pd:B:C en un rapport d'atomes de 1:2:2:1.

3. Procédé selon la revendication 2,
caractérisé en ce que
le mélange de poudre est fabriqué à partir d'une poudre d'éléments ou de pré-alliages d'au moins 2 des composants, ou à partir d'un mélange de pré-alliages et de poudre d'éléments.

4. Procédé selon la revendication 1,
caractérisé en ce que
l'alliage mécanique ou le broyage intensif est effectué au moyen d'un broyeur à boulets planétaire, d'un broyeur oscillatoire, d'un broyeur vibrant ou d'un broyeur à frottement.

5. Procédé selon la revendication 1,
caractérisé en ce qu'
en cas de présence d'une poudre secondaire majoritairement amorphe, la compression est effectuée à des températures situées au moins à 20°K au-dessous de la température de cristallisation de la phase amorphe du matériau.

6. Procédé selon la revendication 1,
caractérisé en ce qu'
en cas de présence d'une poudre secondaire majoritairement nano-cristalline ayant des proportions de phase amorphe < 50% la compression est effectuée à des températures proches de, et inférieures à, la température de cristallisation de la phase amorphe.

7. Procédé selon la revendication 1,
caractérisé en ce qu'
en cas de présence d'une poudre secondaire complètement nano-cristalline, la compression a été effectuée à des températures inférieures à la température de conversion de la phase supraconductrice présente du matériau.

8. Procédé selon la revendication 7,
caractérisé en ce qu'
en cas de présence d'une poudre secondaire complètement nano-cristalline, la compression a été effectuée à des températures inférieures à 900°C.

9. Procédé selon la revendication 1,
caractérisé en ce que
le compactage est effectuer pour donner des corps moulés supraconducteurs, au moyen d'un pressage à chaud, d'un boudinage, d'une extrusion, d'une compression isostatique à chaud ou d'un frittage à compression isostatique à température élevée.

10. Procédé selon la revendication 1,
caractérisé en ce que
le traitement thermique, pour obtenir la formation des phases supraconductrices, et la compression, pour assurer la fabrication des corps moulés supraconducteurs, sont effectués en une étape technologique commune.
